# EUROPEAN PATENT APPLICATION

(11) **EP 2 924 752 A1**
(43) Date of publication of application: **30.09.2015**
(21) Application number: 15156991.0
(22) Date of filing: 27.02.2015
(51) Int. Cl.: H01L 49/02, H01L 23/522, H01L 23/64

(54) **MIM capacitor and method of manufacturing MIM capacitor**

(30) Priority: 28.03.2014 JP 2014068409
(71) Applicant: Kabushiki Kaisha Toshiba, Tokyo 105-8001 (JP)
(72) Inventor: Matsushita, Keiichi, Tokyo (JP)
(74) Representative: Granleese, Rhian Jane

(57) **Abstract**

Certain embodiments provide an MIM capacitor including a lower electrode 12, an insulating film 13, an upper electrode 14, and air bridge wiring 17. The lower electrode is provided on a surface of a semiconductor substrate 11. The insulating film is provided on the surface of the semiconductor substrate so as to cover the lower electrode. The upper electrode is provided on a surface of the insulating film, and above the lower electrode. The air bridge wiring is provided a surface of the upper electrode so as to be in contact with only a predetermined region which includes a center point of the surface of the upper electrode.

## Description

### CROSS REFERENCE TO RELATED APPLICATIONS

This application is based upon and claims the benefit of priority from the prior Japanese Patent Application No.2014-068409 filed in Japan on March 28, 2014; the entire contents of which are incorporated herein by reference.

### FIELD

Embodiments described herein relate generally to an MIM capacitor, and a method of manufacturing an MIM capacitor.

### BACKGROUND

Typically, a metal-insulator-metal (MIM) capacitor is included in an IC for microwave used in the telecommunications field, and the like. In a conventional MIM capacitor, an end portion of an upper electrode is connected to air bridge wiring, and the MIM capacitor is connected to other elements, wiring, and the like included in the IC through the air bridge wiring.

In such a conventional MIM capacitor, if the upper electrode and a lower electrode are increased in size in order to especially secure a large capacity, stress such as thermal stress applied to the upper electrode and the lower electrode becomes large. This stress is concentrated at an end portion of the MIM capacitor including the end portion of the upper electrode to which the air bridge wiring is connected. As a result, there are problems that, in a process of manufacturing the MIM capacitor, for example, a crack is caused in an insulating film having weaker strength than the upper electrode and the lower electrode and included in the end portion of the MIM capacitor, and the yield of the MIM capacitor is decreased.

### BRIEF DESCRIPTION OF THE DRAWINGS

FIG. 1 is a cross sectional view of essential parts of an MIM capacitor according to an embodiment;
FIG. 2 is a plan view of the MIM capacitor illustrated in FIG. 1 as viewed from above;
FIG. 3A is a diagram for describing a definition of a center point of an upper electrode of the MIM capacitor;
FIG. 3B is a diagram for describing a definition of the center point of the upper electrode of the MIM capacitor;
FIG. 4 is a plan view corresponding to FIG. 2, illustrating a modification of the MIM capacitor;
FIG. 5 is a cross sectional view corresponding to FIG. 1, for describing a method of manufacturing an MIM capacitor according to an embodiment;
FIG. 6 is a cross sectional view corresponding to FIG. 1, for describing the method of manufacturing an MIM capacitor according to an embodiment;
FIG. 7 is a cross sectional view corresponding to FIG. 1, for describing the method of manufacturing an MIM capacitor according to an embodiment;
FIG. 8 is a cross sectional view corresponding to FIG. 1, for describing the method of manufacturing an MIM capacitor according to an embodiment;
FIG. 9 is a cross sectional view corresponding to FIG. 1, for describing the method of manufacturing an MIM capacitor according to an embodiment;
FIG. 10 is a cross sectional view corresponding to FIG. 1, for describing the method of manufacturing an MIM capacitor according to an embodiment;
FIG. 11 is a cross sectional view corresponding to FIG. 1, for describing the method of manufacturing an MIM capacitor according to an embodiment; and
FIG. 12 is a cross sectional view corresponding to FIG. 1, for describing the method of manufacturing an MIM capacitor according to an embodiment.

### DESCRIPTION OF THE EMBODIMENTS

Certain embodiments provide an MIM capacitor including a lower electrode, an insulating film, an upper electrode, and air bridge wiring. The lower electrode is provided on a surface of a semiconductor substrate. The insulating film is provided on the surface of the semiconductor substrate so as to cover the lower electrode. The upper electrode is provided on a surface of the insulating film, and above the lower electrode. The air bridge wiring is provided a surface of the upper electrode so as to be in contact with only a predetermined region which includes a center point of the surface of the upper electrode.

Certain embodiments provide a method of manufacturing an MIM capacitor, the method including forming a lower electrode, forming an insulating film, forming an upper electrode, and forming air bridge wiring. The lower electrode is formed on a surface of a semiconductor substrate. The insulating film is formed on the surface of the semiconductor to cover the lower electrode. The upper electrode is formed on a surface of the insulating film, and above the lower electrode. The air bridge wiring is formed on a surface of the upper electrode to be in contact with only a predetermined region including a center point of the surface.

Hereinafter, an MIM capacitor and a method of manufacturing an MIM capacitor according to an embodiment will be described.

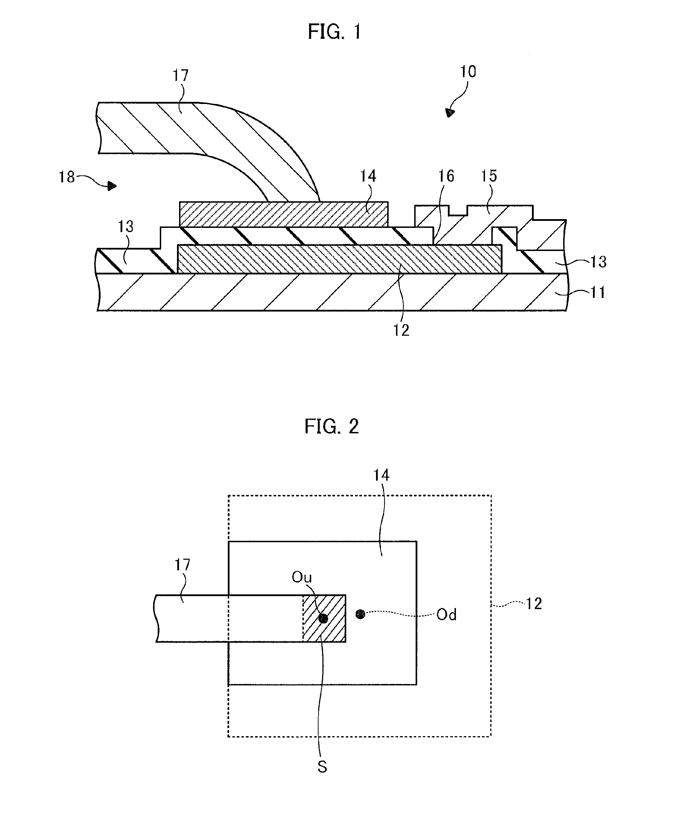

FIG. 1 is a cross sectional view of essential parts of an MIM capacitor 10 according to an embodiment. The MIM capacitor 10 illustrated in FIG. 1 is provided on a surface of a semiconductor substrate 11 configured from materials such as Si, GaN, and GaAs, and includes a lower electrode 12, an insulating film 13, and an upper electrode 14.

That is, the lower electrode 12 made of metal is provided on the surface of the semiconductor substrate 11. The lower electrode 12 is formed such that a plurality of metal films is laminated, for example, and has the thickness of about 600 nm to 1 µm. In the MIM capacitor 10 according to an embodiment, the lower electrode 12 is configured such that an Au film, a Pt film, and a Ti film are laminated in this order.

Further, the insulating film 13 is formed on the surface of the semiconductor substrate 11 to cover the lower electrode 12. This insulating film 13 is configured from any one of a SiN film, a SiO₂ film, and the like, and has the thickness of about 100 to 300 nm.

Further, the upper electrode 14 made of metal is provided on a surface of the insulating film 13 and at a position corresponding to above the lower electrode 12. The upper electrode 14 has an area smaller than an area of a surface of the lower electrode 12. The upper electrode 14 is formed such that a plurality of metal films is laminated, for example, and has the thickness of about 600 nm to 1 µm. In the MIM capacitor 10 according to an embodiment, the upper electrode 14 is configured such that a Ti film, a Pt film, and an Au film are laminated in this order.

Further, wiring 15 is connected to the lower electrode 12. An opening 16 that allows the lower electrode 12 to be exposed is provided in a region of the insulating film 13 on the lower electrode 12, and the wiring 15 is provided on a surface of the insulating film 13 such that an end of the wiring 15 is connected to the lower electrode 12 exposed through the opening 16. The wiring 15 is configured from metal containing Au as a main component, for example, and has the thickness of about 600 to 1000 nm, which is similar thickness to the insulating film 13.

Meanwhile, air bridge wiring 17 is connected to the upper electrode 14. The air bridge wiring 17 is provided such that one end surface of the air bridge wiring 17 is connected to a surface of the upper electrode 14, and the other portion except the one end surface is upwardly separated from the surface of the insulating film 13 and the surface of the upper electrode 14. The air bridge wiring 17 is configured from metal containing Au as a main component, for example.

Note that a region between the air bridge wiring 17 and the surface of the upper electrode 14, excluding a portion where the air bridge wiring 17 and the surface of the upper electrode 14 are in contact with each other, is a space 18. Although not illustrated, this space 18 may be filled with an insulating material.

FIG. 2 is a plan view of the above-described MIM capacitor 10 as viewed from above. Note that, in FIG. 2, the insulating film 13 is omitted, and the lower electrode 12 is illustrated by a dotted line. As illustrated in FIG. 2, the air bridge wiring 17 is in contact with only a central region of the surface of the upper electrode 14, and is provided to upwardly separated from an end portion region of the surface of the upper electrode 14. That is, the air bridge wiring 17 is provided such that a contact region S of the end surface of the air bridge wiring 17 and the surface of the square-shaped upper electrode 14 is formed only on the central region of the surface of the upper electrode 14 (FIG. 1).

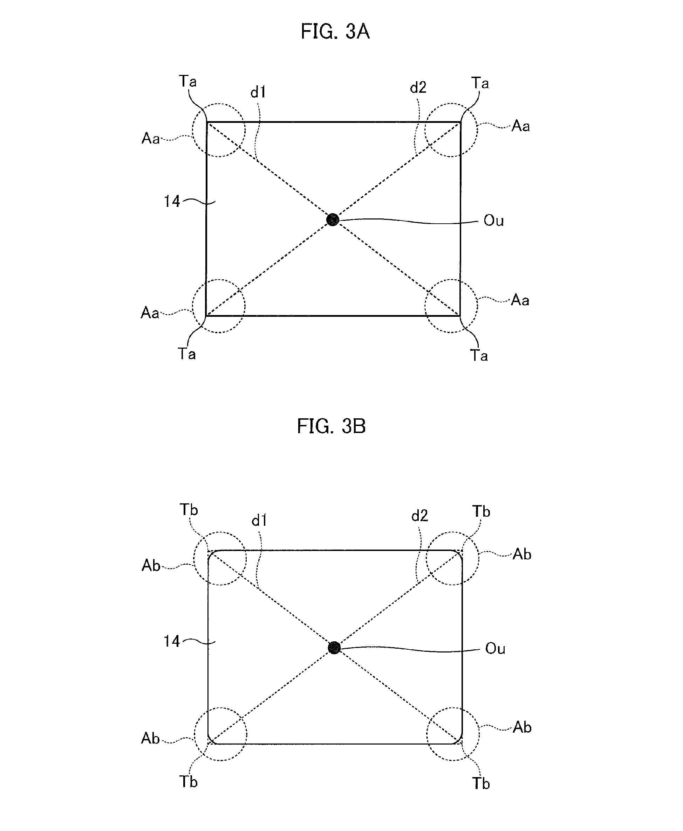

Hereinafter, the central region and end portion region of the surface of the upper electrode 14 will be described in more detail. Here, a center point Ou of the surface of the upper electrode 14 is defined as follows. As illustrated in FIGS. 3A and 3B, an intersection of two diagonal lines d1 and d2 is defined as the center point Ou, where the surface of the upper electrode 14 is substantially a square. Substantially a square includes a shape with four corner portions Aa respectively having corner points Ta, as illustrated in FIG. 3A, and also includes a shape in which portions corresponding to corner points Tb are removed from four corner portions Ab, as illustrated in FIG. 3B. With the upper electrode 14 having the shape illustrated in FIG. 3B, electric field concentration generated in each of the corner portions Ab can be reduced.

Further, a point of symmetry (a point of center of gravity) is defined as the center point Ou, where the surface of the upper electrode 14 substantially has a point-symmetric shape.

The central region of the surface of the upper electrode 14 is defined using the above-described center point Ou, as follows. That is, the central region of the surface of the upper electrode 14 means a region that includes the center point Ou and does not include a periphery of the upper electrode 14. Further, the end portion region of the surface of the upper electrode 14 is defined as follows. That is, the end portion region of the surface of the upper electrode 14 means a region that includes the periphery of the surface of the upper electrode 14, and surrounds the central region in a ring-shaped manner.

The air bridge wiring 17 is provided such that the contact region S of the air bridge wiring 17 and the surface of the upper electrode 14 is formed in the central region as defined above, and the center point Ou of the upper electrode 14 is included in the contact region S. That is, the air bridge wiring 17 is provided on the surface of the upper electrode 14 to be in contact with only the predetermined region including the center point Ou.

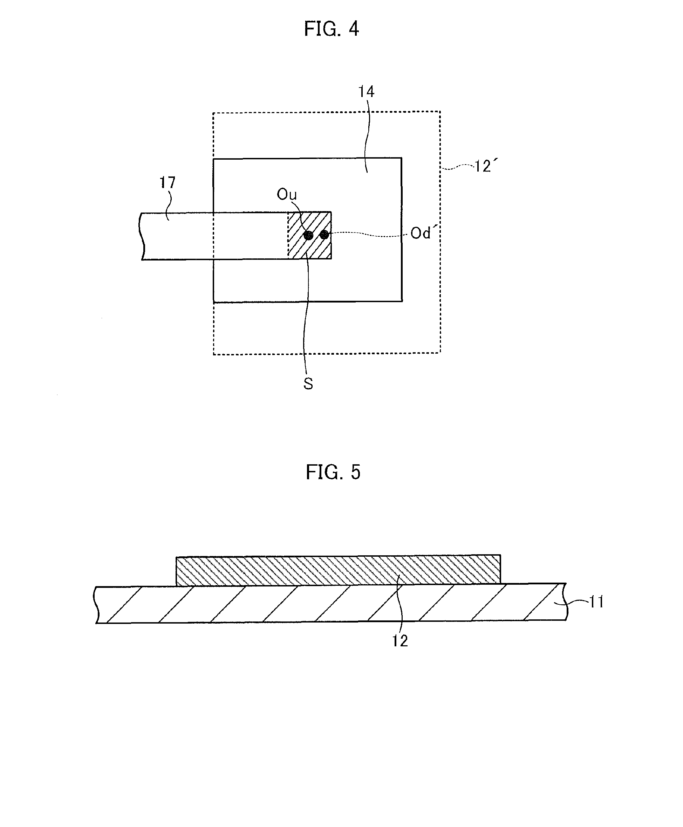

Note that the air bridge wiring 17 may be provided such that an immediately upper portion of a center point Od of the surface of the square-shaped lower electrode 12 is not included inside the contact region S, as illustrated in FIG. 2, or may be provided such that an immediately upper portion of a center point Od' of the surface of a square-shaped lower electrode 12' is included inside the contact region S, as illustrated in FIG. 4. Here, definitions of the center points Od and Od' of the lower electrodes 12 and 12' are similar to the center point Ou of the upper electrode 14, and thus description is omitted.

Next, a method of manufacturing the above-described MIM capacitor 10 will be described with reference to FIGS. 5 to 12. FIGS. 5 to 12 are cross sectional views corresponding to FIG. 1, for describing a method of manufacturing the MIM capacitor 10 according to an embodiment, respectively.

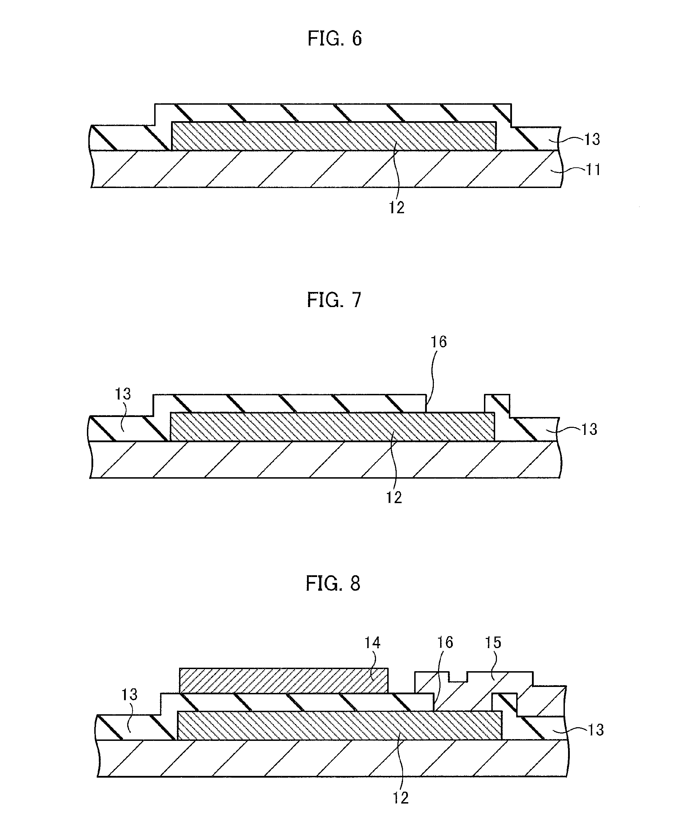

First, as illustrated in FIG. 5, the lower electrode 12 is formed on a predetermined region of the surface of the semiconductor substrate 11. Following that, as illustrated in FIG. 6, the insulating film 13 is formed on the surface of the semiconductor substrate 11 to cover the lower electrode 12.

Next, as illustrated in FIG. 7, the opening 16 is formed in a part of the insulating film 13 such that a part of the lower electrode 12 is exposed.

Next, as illustrated in FIG. 8, the upper electrode 14 is formed on the surface of the insulating film 13 on the lower electrode 12, and the wiring 15 is formed on the surface of the insulating film 13 to be connected to the lower electrode 12 exposed through the opening 16 of the insulating film 13. The upper electrode 14 and the wiring 15 may be formed at the same time, or may be formed in separate processes.

Finally, the air bridge wiring 17 is formed on the surface of the upper electrode 14 to be in contact with only the predetermined region including the center point Ou. Note that, while a method of forming the air bridge wiring 17 is not limited, the air bridge wiring 17 is formed by, for example, an electric field plating method, as follows.

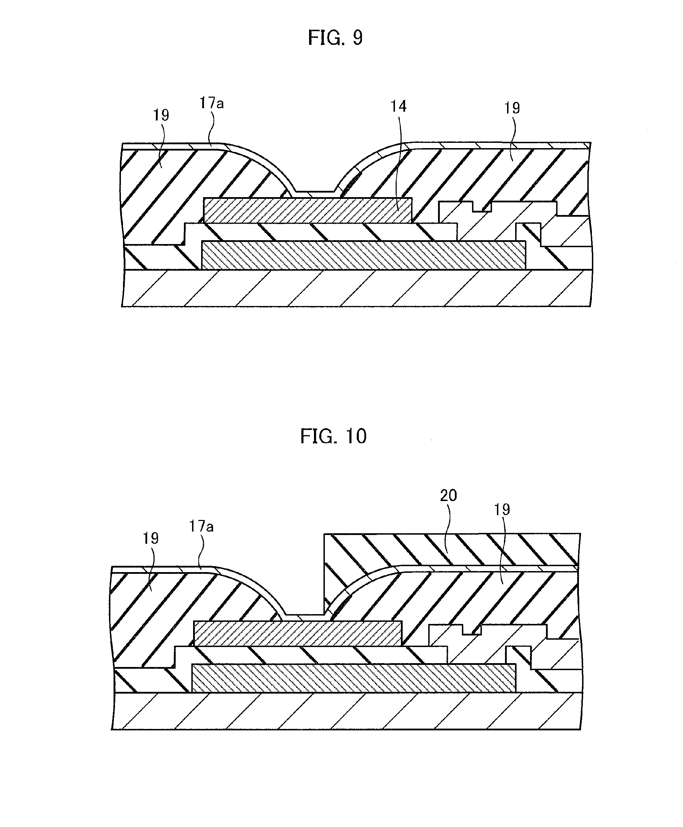

First, as illustrated in FIG. 9, a resist layer 19 is formed such that the predetermined region including the center point Ou of the surface of the upper electrode 14 is exposed, and a metal thin film 17a that serves as an electrode for plating is formed on the surface of the upper electrode 14 exposed from the resist layer 19, and a surface of the resist layer 19. The metal thin film 17a is configured from metal containing Au as a main component, for example.

Next, as illustrated in FIG. 10, a resist layer 20 is further laminated on the resist layer 19 such that the metal thin film 17a existing in a region where the air bridge wiring 17 is to be formed is exposed.

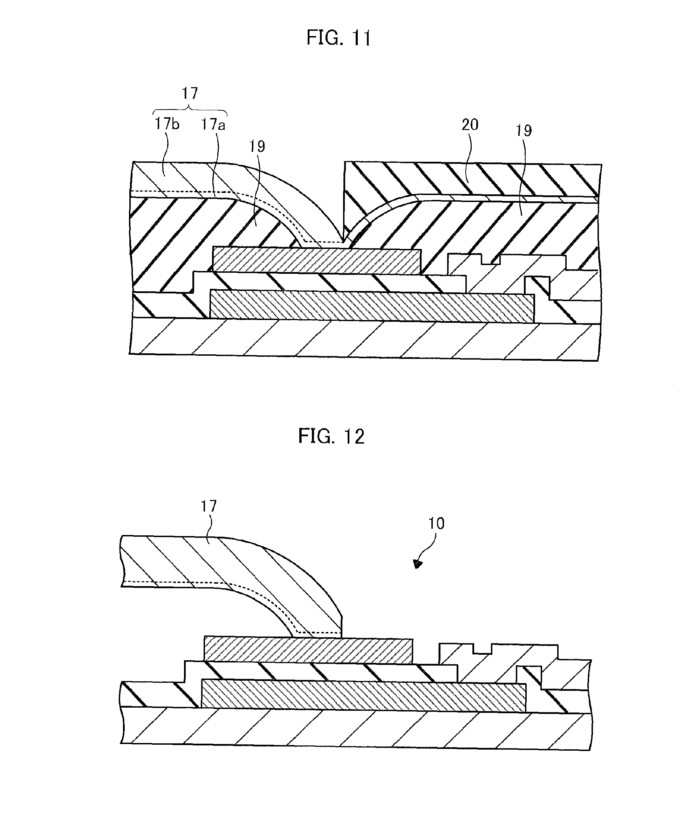

Next, as illustrated in FIG. 11, a metal layer 17b is formed on the metal thin film 17a exposed from the resist layer 20 using an electric field plating method. Similarly to the metal thin film 17a, the metal layer 17b is configured from metal containing Au as a main component, for example. As described above, the air bridge wiring 17 configured from the metal thin film 17a and the metal layer 17b is formed.

As described above, after the air bridge wiring 17 is formed, the resist layers 19 and 20 are removed using an ashing method, for example, so that the MIM capacitor 10 having the air bridge wiring 17, as illustrated in FIGS. 1 and 2, can be manufactured.

According to the MIM capacitor 10 and the method of manufacturing the MIM capacitor 10 described above, the air bridge wiring 17 is provided on the surface of the upper electrode 14 to be in contact with only the predetermined region including the center point Ou. Therefore, even if thermal stress is applied to the MIM capacitor 10 including the air bridge wiring 17, for example, the stress is dispersed in the entire MIM capacitor 10. Therefore, generation of a crack in the insulating film 13 of the MIM capacitor 10 can be suppressed. As a result, the MIM capacitor 10 and the method of manufacturing an MIM capacitor 10 excellent in the yield can be provided.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

In the embodiment, the upper electrode 14 and the lower electrode 12 have square shapes, respectively. However, the shapes of the electrodes 12 and 14 are not limited, and any shapes may be employed as long as the shapes are substantially point-symmetric shapes.

## Claims

1. An MIM capacitor comprising:
a lower electrode provided on a surface of a semiconductor substrate;
an insulating film provided on the surface of the semiconductor substrate so as to cover the lower electrode;
an upper electrode provided on a surface of the insulating film, and above the lower electrode; and
air bridge wiring provided on a surface of the upper electrode so as to be in contact with only a predetermined region which includes a center point of the surface of the upper electrode.

2. The MIM capacitor according to claim 1, wherein the air bridge wiring is provided so as to be upwardly separated from a ring-shaped region of the surface of the upper electrode, the ring-shaped region corresponding to a region excluding the predetermined region from the surface of the upper electrode.

3. The MIM capacitor according to claim 2, wherein a region between the air bridge wiring and the ring-shaped region of the surface of the upper electrode is a space.

4. The MIM capacitor according to any one of claims 1 to 3, wherein the air bridge wiring is configured from a metal thin film for plating, and a metal layer formed on the metal thin film.

5. The MIM capacitor according to any one of claims 1 to 4, wherein an area of the surface of the upper electrode is smaller than an area of a surface of the lower electrode.

6. The MIM capacitor according to any one of claims 1 to 5, wherein an immediately upper portion of the center point of the lower electrode is not included in a contact region of the air bridge wiring and the surface of the upper electrode.

7. The MIM capacitor according to any one of claims 1 to 5, wherein an immediately upper portion of the center point of the lower electrode is included in a contact region of the air bridge wiring and the surface of the upper electrode.

8. The MIM capacitor according to any one of claims 1 to 7, wherein an opening exposing a part of the surface of the lower electrode is provided in the insulating film, and
wiring provided so as to be connected to the lower electrode exposed through the opening is further included.

9. A method of manufacturing an MIM capacitor, the method comprising:
forming a lower electrode on a surface of a semiconductor substrate;
forming an insulating film on the surface of the semiconductor substrate so as to cover the lower electrode;
forming an upper electrode on a surface of the insulating film, and above the lower electrode; and
forming air bridge wiring on a surface of the upper electrode so as to be in contact with only a predetermined region which includes a center point of the surface of the upper electrode.

10. The method of manufacturing an MIM capacitor according to claim 9, wherein the air bridge wiring is formed so as to be upwardly separated from a ring-shaped region of the surface of the upper electrode, the ring-shaped region corresponding to a region excluding the predetermined region from the surface of the upper electrode.

11. The method of manufacturing an MIM capacitor according to claim 10, wherein the air bridge wiring is formed so as to have a space between the air bridge wiring and the ring-shaped region of the surface of the upper electrode.

12. The method of manufacturing an MIM capacitor according to any or of claims 9 to 11, wherein the air bridge wiring is formed by an electrode field plating method.

13. The method of manufacturing an MIM capacitor according to any one of claims 9 to 12, wherein the upper electrode is formed so that an area of the surface of the upper electrode is smaller than an area of a surface of the lower electrode.

14. The method of manufacturing an MIM capacitor according to any one of claims 9 to 13, wherein the air bridge wiring is formed so that an immediately upper portion of the center point of the lower electrode is not included in a contact region of the air bridge wiring and the surface of the upper electrode.

15. The method of manufacturing an MIM capacitor according to any one of claims 9 to 13, wherein the air bridge wiring is formed so that an immediately upper portion of the center point of the lower electrode is included in a contact region of the air bridge wiring and the surface of the upper electrode.
